Europäisches Patentamt

**European Patent Office**

**Office européen des brevets**

(19)

(11) Numéro de publication : **0 071 550 B1**

(12)

# FASCICULE DE BREVET EUROPÉEN

(45) Date de publication du fascicule du brevet :
**15.05.85**

(21) Numéro de dépôt : **82420105.7**

(22) Date de dépôt : **23.07.82**

(51) Int. Cl.⁴ : **G 02 B 17/06, F 24 J 2/00, H 01 L 31/02**

(54) **Focaliseur semi-statique Fresnel à miroirs croisés.**

(30) Priorité : **23.07.81 FR 8114514**

(43) Date de publication de la demande :
**09.02.83 Bulletin 83/06**

(45) Mention de la délivrance du brevet :
**15.05.85 Bulletin 85/20**

(84) Etats contractants désignés :
**DE GB IT**

(56) Documents cités :
**FR-A- 2 443 592**
**FR-A- 2 468 083**
**GB-A- 2 054 829**
**US-A- 4 266 179**

(73) Titulaire : **Perrier, Jean**
**84 Chemin de l'Aigas**
**F-69160 Tassin la demi lune (FR)**

(72) Inventeur : **Perrier, Jean**
**84 Chemin de l'Aigas**
**F-69160 Tassin la demi lune (FR)**

(74) Mandataire : **Maisonnier, Jean**
**28 rue Servient**
**F-69003 Lyon (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne un instrument du type concentrateur de rayons optiques permettant de maintenir en position stable le foyer de concentration, quand la source radiative émettant des rayons parallèles se déplace, ou inversement, d'émettre des rayons parallèles de direction contrôlable à partir d'une source quasi ponctuelle.

Le domaine technique de l'invention s'étend à l'ensemble de l'optique, aux procédés de repérage directionnels et mesure d'intensité d'une source radiative, à l'émission de rayonnements parallèles de coordonnées sphériques variables, et aux systèmes de captation industriels d'énergie solaire.

Dans la technique actuelle, la stabilisation de l'image d'une source radiative lointaine, comme le soleil, est obtenue par différents procédés, essentiellement des héliostats plans disposés en champ pour les installations de grosse puissance ou des miroirs concaves montés sur équipages mobiles tournant autour de leur foyer. Ces systèmes ont l'inconvénient d'exiger le mouvement de pièces volumineuses et mal profilées aérodynamiquement, donc instables dans le vent.

Des améliorations ont été apportées en remplacement de cylindres paraboliques, en utilisant des miroirs de Fresnel longilignes, à axes parallèles, soit fixes s'ils sont disposés sur un profil de coupe circulaire, soit mobiles autour de leur axe longiligne avec décalages angulaires constants. Les premiers ont l'inconvénient d'exiger que le lieu de focalisation reste lui-même sur le profil circulaire ; les deux systèmes ont le désavantage majeur de concentrer l'énergie linéairement sur une source linéaire ce qui présente des graves problèmes d'éclairement incomplet dès que la source n'est pas dans le plan méridien des miroirs, et de concentration insuffisante par rapport aux systèmes concaves à foyer concentré en trois dimensions.

Le nouveau système permet d'obtenir la stabilité du foyer de radiations concentrées à l'aide de très faibles mouvements des pièces petites, à l'intérieur de cadres fixes, sans avoir à déplacer l'ensemble du système réfléchissant et il résout la majorité des problèmes de concentration maximale sur le foyer. L'objet de la présente invention est défini dans la revendication 1.

La présente invention est remarquable en ce qu'elle associe d'une part un châssis fixe support et deux ensembles réfléchissants portés par le châssis, composés chacun d'un cadre et de miroirs plans mobiles reliés par un système de mêmes déplacements angulaires d'un type quelconque autour d'axes parallèles fixés sur deux côtés du cadre, à partir d'une position de repos pour laquelle les miroirs sont calés en échelons du miroir de Fresnel équivalent à un miroir cylindro-parabolique concave, de même foyer optique linéaire sous radiations incidentes parallèles, et d'autre part les systèmes de commande manuels ou motorisés des systèmes de déplacements angulaires communs des jeux de miroirs, chacun des ensembles cadre-miroirs étant disposé de telle manière que les directions des axes de rotation des deux systèmes de miroirs associés soient perpendiculairement entre eux dans l'espace et que les rayons réfléchis par l'un des ensembles soient totalement ou partiellement interceptés par l'autre.

La présente invention est aussi remarquable en ce que, dans une de ses formes, les miroirs des systèmes sont calés en position de repos par le système de mêmes déplacements angulaires par blocage desserable permettant de modifier la position géographique du foyer, pour la même direction de rayons incidents.

La présente invention est aussi remarquable en ce que, dans une de ses formes, sont installés au foyer de pseudo-focalisation, un thermostat différentiel électrique, fluidique, ou opto-électronique, captant l'effet différentiel de la température ambiante et du rayonnement, et sur le système de déplacement angulaire d'un des systèmes de miroirs, une commande motorisée électrique, magnétique, fluidique, ou quelconque, imprimant aux miroirs un mouvement angulaire alternatif, balayant tout le champ angulaire de la course de la source de radiations mobile, le thermostat différentiel interrompant, par course directe ou assistée, et dès lors qu'il reçoit et absorbe le pinceau de radiations focalisées, l'énergie d'alimentation de la commande motorisée du déplacement.

La présente invention est aussi remarquable en ce que, dans une de ses formes, les deux ensembles de cadre-miroirs sont motorisés et équipés de thermostats différentiels indépendants contrôlant l'énergie de motorisation.

La présente invention est aussi remarquable en ce que, dans une de ses formes, est installé au foyer, avec ou sans le thermostat différentiel précité, un ensemble de cellules photoélectriques voltaïques, regroupées ou non, ou un échangeur d'énergie thermo-absorbant à fluide, transformant et rendant utilisable l'énergie de radiation concentrée au foyer par le jeu des systèmes optiques d'ensemble.

La présente invention est aussi remarquable en ce que, dans une de ses formes, est installée au foyer une source radiative d'un type quelconque, électrique ou non, dont les rayons incidents sont transformés par l'appareil en faisceau de rayons parallèles orientables au gré de la commande des deux systèmes de déplacement angulaires, dans toutes les directions de l'espace.

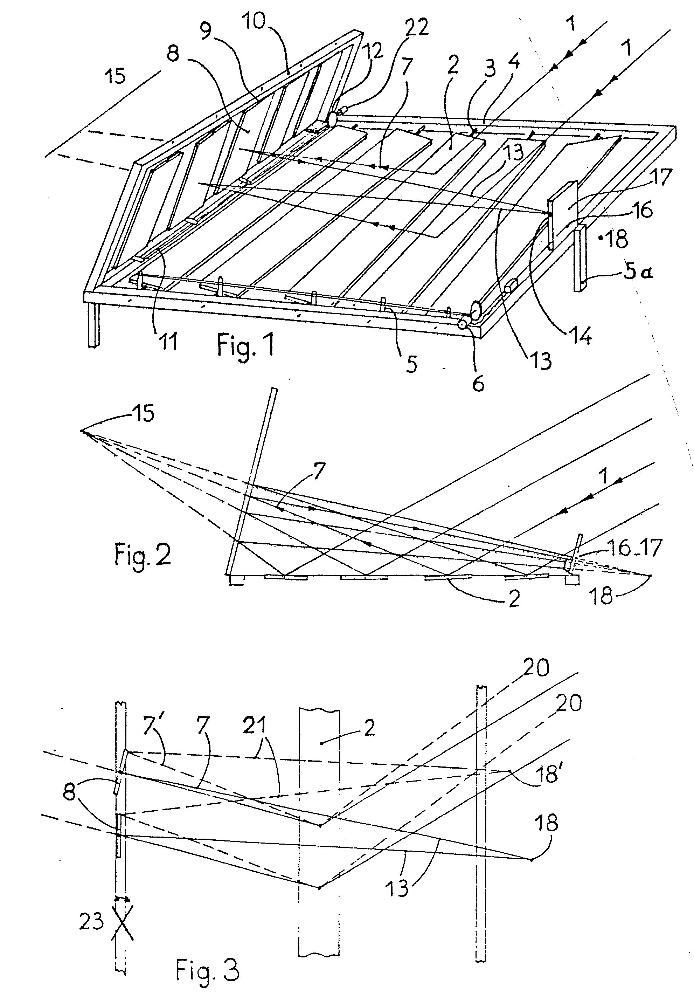

L'instrument appelé focaliseur semi-statique de Fresnel à miroirs croisés perpendiculairement, est représenté dans l'une de ses formes, par une planche de dessins comportant les figures 1, 2, et 3.

Suivant la figure 1, qui représente l'une des formes les plus complètes de l'invention, les rayons 1, reçus d'une source lointaine, sont réfléchis par le miroir échelon Fresnel 2 du premier système cadre-miroirs formés du cadre 4 prenant appui sur le bâti triépied 5a. Les miroirs 2 tournent autour des axes parallèles 3 et sont reliés par un parallélogramme déformable 5 assurant une même rotation des miroirs 2, dont le calage primitif concentre les rayons 1 sur une focale linéaire 15. Cet ensemble ne fait pas partie de la nouveauté, puisqu'il est du domaine public. Un moteur électrique 6 commande la parallélogramme 5, pour l'orientation des échelons 2. Toujours suivant la figure 1, le rayon réfléchie 7 du rayon 1 est reçu par le miroir 8 du deuxième ensemble cadre-miroirs, associant les miroirs 8, le cadre 10, et les axes de rotation 9 dont la particularité suivant l'invention est d'être perpendiculaires en direction à celle des axes 3. Le calage du miroir 8 sur son système de même déplacement angulaire 11 est tel qu'au repos de réglage, le rayon 7 est réfléchi suivant le rayon 13 sur le thermostat différentiel 16 et le capteur 17 qui forment une cible fixe centrée sur le point de convergence théorique 18. Tous les miroirs 2 et 8 sont calés au repos de réglage sur les cibles 15 et 18, et forment des échelons Fresnel de deux miroirs concaves cylindro-paraboliques d'axes perpendiculaires, étant entendu que ce système croisé bénéficie des propriétés physiques explicitées suivant les figures 2 et 3.

Suivant la figure 2, les perpendiculaires au miroir 2 sont dans le plan de cette figure, et, d'après l'égalité des angles d'incidence et de réflexion sur un miroir, il est possible de caler chaque miroir 2 pour faire converger 7 sur la cible 15. Si les rayons 1 tournent en projection d'un angle déterminé, il suffit de faire tourner les miroirs 2 de la moitié de cette rotation, pour ramener l'image de la source lointaine à travers l'ensemble des miroirs 2 sur la droite, dont la trace est le point cible 15.

Suivant la figure 3, on constate que, puisque 2 est un miroir-plan, les rayons réfléchis 7 des rayons 1 tombant sur un miroir 2 restent parallèles entre eux et en étendent l'exposé qui vient d'être fait pour le premier ensemble cadre-miroirs au second. On constate suivant la figure 3 qu'il est possible de caler les miroirs 8 pour qu'en projection, les rayons 13 réfléchis de 7 convergent sur la projection de 18. Ainsi, suivant l'ensemble des figures 2 et 3, l'image de la source lointaine émettant les rayons 1 est à travers le premier ensemble cadre-miroirs une portion de la droite focale 15 parallèle aux axes 3, et, grâce à la perpendicularité des directions des axes 3 et 9 de l'invention, cette portion linéaire a pour image la cible quasi ponctuelle 18.

Suivant la figure 3, on constate aussi que si la source se déplace et émet des rayons 20 décalés de la direction des rayons 1, les rayons 13 se transforment en rayons 21 qui ne convergent plus sur la cible 18 et n'échauffent plus le thermostat différentiel 15 qui se refroidit et ferme par contact le circuit d'alimentation énergétique du moteur 22 de commande du parallélogramme déformable 12. Les miroirs 18 se mettent à osciller alternativement dans l'angulation 23 calculée pour que la convergence en 18 des rayons 1 suivant la figure 3, soit toujours possible. Quand le faisceau des rayons 21 vient à passer devant la cible 18, le thermostat différentiel ouvre le circuit d'alimentation du moteur 22, et le système s'arrête en position stable devant le capteur 16 qui récupère l'énergie à un très haut niveau de concentration et le transmet au système d'utilisation non représenté sur les figures de la planche.

L'application à deux thermostats permet évidemment de contrôler la focalisation aussi bien en hauteur qu'azimuth sidéraux. Il est évident qu'en raison du principe du retour inverse de la lumière si une source irradiante est placée en 18, ses rayons sont transformés en rayons parallèles 1 dont la hauteur et l'azimuth astraux sont contrôlables à volonté en commandant les systèmes 5 et 12.

De manière industrielle, l'appareil est utilisable de manières multiples, puisqu'il s'adapte à toutes radiations. Dans le domaine de la production énergétique, c'est un capteur à concentration de poursuite du soleil ; il travaille indépendamment de la position du châssis fixe et se fixe sur toute paroi. Dans le domaine des repérages et mesures, il peut s'adapter à des émetteurs variés, les miroirs peuvent être des antennes réfléchissantes, et, associé à une mesure des vitesses de propagation d'ondes, il s'intègre au système de suivi d'engins mobiles. Dans le domaine des essais de matériel de captation d'énergie, il permet de réaliser des chambres solaires artificielles à éclairages parallèles orientables et sans ondes composées transversales à l'onde principale.

## Revendications

1. Ensemble optique à deux cadres d'ossature (4) et (10) portés par un châssis fixe (5a) et munis chacun d'un miroir cylindrique de Fresnel à échelons élémentaires réfléchissants plans (2 et 8) dont les inclinaisons progressives permettent pour chacun de ces deux miroirs de Fresnel une focalisation linéaire, chacun des échelons réfléchissants plans (2 ou 8) étant porté par un axe parallèle à son plan et autour duquel il peut osciller sous l'action de moyens de commande communs d'une part à tous les échelons élémentaires (2) dont les axes (3) sont parallèles entre eux dans le premier cadre (4) d'autre part à tous les échelons élémentaires (8) dont les axes (9) sont parallèles entre eux dans le second cadre (10), caractérisé en ce que les plans des cadres (4 et 10) forment un dièdre réfléchissant d'angle au sommet inférieur ou égal à 90°, tandis que la direction des axes d'oscillation (3) des échelons réfléchissants (2) du premier cadre (4) est perpendiculaire à la direction des axes d'oscillation (9) des échelons réfléchissants (8) du second cadre (10), de façon à focaliser un rayonnement incident (1) sur une cible (17).

2. Ensemble optique suivant la revendication 1, caractérisé en ce que les moyens de commande d'angulation sont reliés aux échelons élémentaires réfléchissants (2) et (8) par un système de blocage serrable et desserable.

3. Ensemble optique suivant les revendications 1 et 2, caractérisé en ce que le premier miroir de Fresnel (2, 3, 4) est associé à une commande (5) à moteur (6), alternative et sans fin, pour l'angulation des échelons élémentaires (2), cette commande (5) étant alimentée à partir d'une source d'énergie indépendante et à partir d'un thermostat différentiel (16) placé près de la cible de focalisation.

4. Ensemble optique suivant la revendication 3, caractérisé en ce que le second miroir de Fresnel (8, 9, 10) est associé à une commande (12) à moteur (22), alternative et sans fin, pour l'angulation des échelons élémentaires (8), cette commande (12) étant alimentée à partir d'une source d'énergie indépendante et à partir du thermostat différentiel (16) placé près de la cible de focalisation (17).

5. Ensemble optique suivant l'une quelconque des revendications précédentes, caractérisé en ce qu'à la cible de focalisation (17) sont associés des moyens pour la captation de l'énergie, tels que des cellules voltaïques ou à absorbeur thermo-fluide.

6. Ensemble optique suivant l'une quelconque des revendications précédentes, caractérisé en ce que lui sont associés, d'une part une source irradiante quasi ponctuelle placée au foyer (18) et émettant vers l'ensemble du premier miroir de Fresnel (2, 3, 4), d'autre part un système pour le contrôle manuel ou asservi des systèmes de commande d'équi-angulation des échelons.

7. Ensemble optique suivant l'une quelconque des revendications précédentes, caractérisé en ce qu'il est incorporé à un générateur d'énergie solaire pour recevoir et focaliser les rayons du soleil.

**Claims**

1. Optical assembly having two frames (4) and (10) carried by a fixed chassis (5a), each of them provided with a Fresnel cylindrical mirror having plane elementary reflectors (2 and 8) the progressive inclination of which defining for each of said Fresnel mirrors a linear focalization, whereas each of said elementaryreflectors (2 or 8) is carried by an axle parallel to its plane and adapted to be oscillated about said axle by means of central driving means, the latter being common both to all elementary reflectors (2) with axles (3) parallel to eachother in the first frame (4) on the one hand, and to all elementary reflectors (8) with axles (9) parallel to eachother in the second frame (10), characterized in that the planes of both frames (4 and 10) define a reflecting diedre having an angle of 90 degrees or less, whilst the direction of axles (3) in said first frame (4) is perpendicular to the direction of axles (9) in said second frame (10), so that incident beams (1) are focalized onto a target (17).

2. Optical assembly according to claim 1, wherein said central driving means are connected with elementary plane reflectors (2 and 8) by a removable latching device.

3. Optical assembly according to claims 1 and 2, wherein said first Fresnel mirror (2, 3, 4) is connected with an endless reciprocal structure (5) driven by a motor (6) for andularly adjusting elementary plane reflectors (2), said structure (5) being powered by means of an independent energy source through a differential thermostat (16) located near said focalization target (17).

4. Optical assembly according to claim 3, wherein said second Fresnel mirror (8, 9, 10) is connected with an endless reciprocal structure (12) driven by a motor (22) for angularly adjusting elementary plane reflectors (8), said structure (12) being powered by means of an independent energy source through said differential thermostat (16) located near said focalization target (17).

5. Optical assembly according to anyone of the above claims, wherein photocells, thermo-fluid absorbing cells or similar energy receiving means are associated to said focalization target (17).

6. Optical assembly according to anyone of the above claims, wherein connection is realized on the one hand with spot irradiating source located at the focus (18) and emitting towards said first Fresnel mirror assembly (2, 3, 4) and on the other hand with a control structure powered or driven by handfor controlling saud driving means for angular adjustment of said reflectors (2, 8).

7. Optical assembly according to anyone of the above claims, wherein is connected with a sun energy generator for receiving and focalizing sunbeams.

**Patentansprüche**

1. Optische Vorrichtung wobei zwei Rahmen (4 und 10) durch einen Chassis (5a) getragen werden, von denen jeder mit einem aus flachen Elementreflektoren (2 und 8) bestimmten zylindrischen Fresnel Spiegel ausgerüstet ist, während bei jedem Fresnel Spiegel linearische Fokalisation durch progressive Orientierung der Reflektoren (2, 8) bestimmt wird, während jeder Elementreflektor (2, 8) bestimmt wird, während jeder Elementreflektor (2, 8) durch eine zu seinem Plan parallele Oszillationsachse worum Oszillation durch eine die alle Reflektoren (2) mit parallelen Achsen (3) im ersten Rahmen (4) auf einer Hand und alle Reflektoren (8) mit parallelen Achsen (9) im zweiten Rahmen (10) Zentralsteuerung gesteuert wird, dadurch gekennzeichnet, dass der Winkel zwischen den beiden Rahmen (4 und 10) weniger als 90 Grad oder bis 90 Grad sich beträgt, während die Richtung der Achsen (3) im ersten Rahmen (4) zur Richtung der Achsen (9) im zweiten Rahmen (10) senkrecht ist, sodass inzident Strahlen (1) auf Ziel (17) fokalisiert werden.

2. Optische Vorrichtung nach Anspruch 1, dadurch gekennzeichnet, dass die obererwähnte Zentralsteuerung mit den flachen Elementreflektoren (2 und 8) durch eine lösbare Verriegelungsvorrichtung verbunden ist.

3. Optische Vorrichtung nach Ansprüche 1 und 2, dadurch gekennzeichnet, dass der erste Fresnel Spiegel (2, 3, 4), mit einer durch Motor (6) gesteuerte endlose Wechselsteuerung (5) die die Flach reflektoren (2) Winkelorientierung einsetzen kann, in Verbindung ist während die Wechselsteuerung (5) durch einen nahe beim Ziel (17) liegenden Differenzialthermostat (16) von einer unabhangigen Energiequelle angetrieben wird.

4. Optische Vorrichtung nach Anspruch 3, dadurch gekennzeichnet, dass der zweite Fresnel Spiegel (8, 9, 10) mit einer durch Motor (22) gesteuerte endlose Wechselsteuerung (12) die die Flachreflektoren (8) Winkelorientierung einsetzen kann, in Verbindung ist, während die Wechselsteuerung (12) durch den nahe beim Fokalisationsziel (17) liegenden Differenzialthermostat (16) von einer unabhängigen Energiequelle angetrieben ist.

5. Optische Vorrichtung nach einer der Ansprüche 1 bis 4, dadurch gekennzeichnet, dass Fotozellen, Thermoflüssigzellen o. degl. Energieaufnemendevorrichtungen mit dem Fokalisationsziel (17) in Verbindung sind.

6. Optische Vorrichtung nach einer der Ansprüche 1 bis 5, dadurch gekennzeichnet dass die, auf einer Hand mit einer am Fokus (18) liegenden austrahlenden Punktquelle die in der Richtung nach dem ersten Fresnel Spiegel (2, 3, 4) ausstrahlt, und auf der anderen Hand, mit einer Hand- oder Motor-getriebenen die Wechselsteuerungen (5 und 12) betätigenden Steuerstruktur, in Verbindung ist.

7. Optische Vorrichtung nach einer der Ansprüche 1 bis 6, dadurch gekennzeichnet, dass sie die Sonnenbestrahlung bekommt und fokalisiert, während sie mit einem Sonnenenergiegenerator verbunden ist.

Fig. 1

Fig. 2

Fig. 3